Europäisches Patentamt

European Patent Office

Office européen des brevets

(19)

(11) Publication number: **0 243 059**

A2

# (12) EUROPEAN PATENT APPLICATION

(21) Application number: **87303196.7**

(22) Date of filing: **13.04.87**

(51) Int. Cl.³: **H 01 J 49/46**
**H 01 J 37/285**

(30) Priority: **22.04.86 GB 8609739**

(43) Date of publication of application:
**28.10.87 Bulletin 87/44**

(84) Designated Contracting States:
**DE FR GB**

(71) Applicant: **SPECTROS LIMITED**
**Barton Dock Road**
**Urmston Manchester M31 2LD(GB)**

(72) Inventor: **Walker, Andrew Roderick**
**40, Legh Road**
**Prestbury Cheshire SK10 4HZ(GB)**

(74) Representative: **Taylor, Derek George et al,**
**MATHISEN, MACARA & CO. The Coach House 6-8**
**Swakeleys Road**
**Ickenham Uxbridge UB10 8BZ(GB)**

(54) **A charged particle analyser.**

(57) A charged particle analyser, in which a specimen is irradiated to emit charged particles, includes a lens (6) and a mask-forming apertured plate (5) disposed between the specimen (1) and the lens (6). The plate (5) contains an aperture (5a) in a first flat portion (5b) covering the specimen, and a second mask-forming portion (5c) is inclined to the first portion and extends adjacent the cone which defines the path of particles passing from the aperture (5a) to the lens. The plate (5) can be formed as a truncated conical shell.

FIG. 2

Croydon Printing Company Ltd.

This invention relates to a charged particle analyser, such for example as an electron energy analysing microscope or spectrometer. Although the invention is applicable to the analysis of various charged particles, reference will be made in particular to photoelectrons.

It is known for example from GB-A-1,552,069 to provide a charged particle analyser having an axis along which charged particles can pass, means for mounting a specimen in a specimen position on the axis of the analyser, a radiation source for directing radiation at an acute angle to said axis on to the surface of a specimen located in said specimen position to cause charged particles to be emitted from said specimen, analysing means for analysing charged particles received from said specimen, a lens on said axis between the specimen position and the analysing means, a first plate having an aperture, the aperture being located on said axis between said lens and said analysing means, said lens and the size and location of the first plate aperture broadly defining a selected area of the specimen from which the analysing means can receive charged particles, and a second plate containing an aperture, the aperture of the second plate being located on said axis between the lens and the specimen position, said second plate having a masking portion which masks the downstream facing side of the second plate from the radiation.

In such an apparatus a relatively large area of the specimen surface is imaged in the focal plane of the lens and the part of that area which is to be analysed is varied by moving the charged particle beam relative to the aperture of the first plate. In normal practice the second plate in apparatus of this type is located at a substantial distance from the specimen such as will enable a large area of the specimen to be irradiated at any one moment, and imaged in the focal plane of the lens.

It is also known from GB-A-1332207 to provide a second aptertured plate between the specimen and the lens wherein the aperture of the second plate limits the area of the specimen which is imaged in the focal plane of the lens. Even so, the area of the specimen from which charged particles are received has hitherto been many times the area of the aperture of the second plate.

When a specimen is irradiated by a source of X-rays or other radiation, electrons will be emitted from the specimen over a wide angle from all irradiated areas.

Consequently, electrons may be collected from an area greater than the selected area. Moreoever, standing magnetic fields in the lens system can be sufficient to ·deflect the trajectories of electrons. The amount of deflection is dependent on the electron energy and hence the selected area position may not remain constant during the acquisition of a photo-electron energy spectrum.

These disadvantages can be mitigated in accordance with the present invention in that the second apertured plate is arranged so close to the specimen position as to limit the area of the specimen from which the lens can receive charged particles to a circle whose diameter is not greater than twice the diameter of the aperture of the second plate.

In particular, the second apertured plate including the masking portion can be formed as a truncated conical shell of which the smaller end contains the aperture.

The invention is illustrated by way of example in the accompanying drawings in which:-

Figure 1 is a diagrammatic illustration of one form of known charged particle analyser to which the present invention is applicable;

Figure 2 is a diagrammatic axial section through an electron-optical lens system utilising an X-ray source to irradiate a specimen and including a field aperture mask-forming plate in accordance with the invention;

Figure 3 is a diagrammatic plan view of the field aperture mask-forming plate of the system of Figure 2, and

Figure 4 is a diagrammatic sectional view of an alternative form of mask-forming plate.

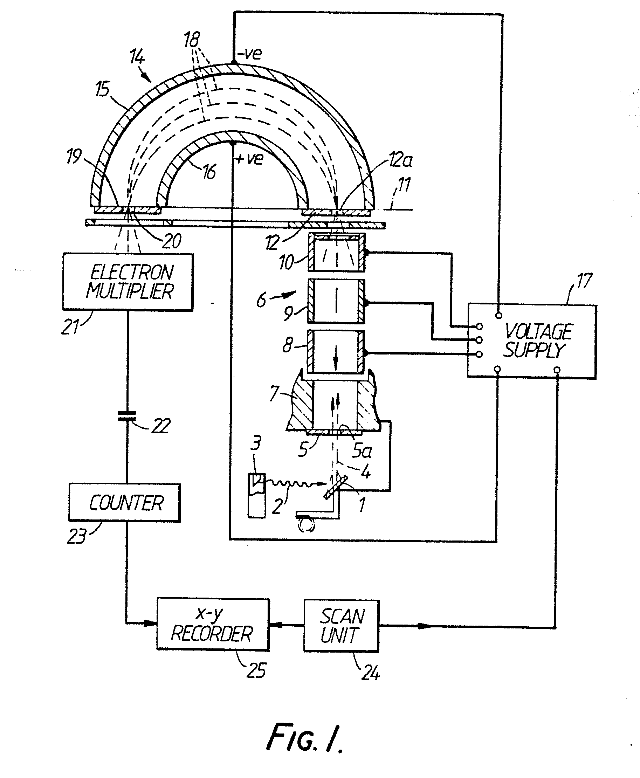

Figure 1 illustrates a charged particle analyser (as in GB-A-1,332,207) in which a specimen 1, mounted in a specimen position within a specimen chamber (not shown), is arranged to be irradiated over an extended area by means of a beam 2 of X-rays, produced, for example, from a target 3 under electron bombardment. Electrons 4 emitted from the irradiated specimen 1 pass through the aperture 5a of a plate 5 held at the same potential as the specimen 1 into an electron optical focussing means 6 consisting of spaced apart components 7-10.

In operation, when suitable potentials are applied to the components 8-10, as described in GB-A-1,332,207 the electrons 4 are focussed to form an electron-optical image, in an image plane 11, of the area of the specimen forming the source of the electrons passing through aperture 5a. The image can vary in magnification with respect to specimen 1 by a factor greater than unity.

The image plane 11 coincides with the entry plane of a hemispherical electrostatic analyser 14, comprising a field defining plate 12 and a pair of metal hemispheres 15,16 mounted concentrically and mutually electrically insulated.

In operation, a voltage is applied between the hemispheres 15,16 from a supply 17 to cause electrons passing through apertured plate 5 and entering the space between the hemispheres to follow curved trajectories 18 to form an electron optical image of the aperture 5a in the exit plane 19 of the analyser. Electrons with different energies from the selected energy range will follow trajectories of different radii of curvature and will therefore be focussed in different positions.

An exit slit 20 serves to select electrons in a certain limited range of the energy spectrum, and these electrons are detected by an electron multiplier 21, the output of which is connected via a capacitor 22 to a counter 23. The output of the counter 23 can be fed to the Y input of an X-Y recorder 25 (for example a strip chart recorder), the X input being fed from a scan unit 24. A parallel focal plane detector can alternatively be used.

The area of the specimen from which electrons are received in the apparatus described above, will depend on the size and location of the aperture 5a of the plate 5, and of the aperture 12a of the plate 12 in the image plane of the lens.

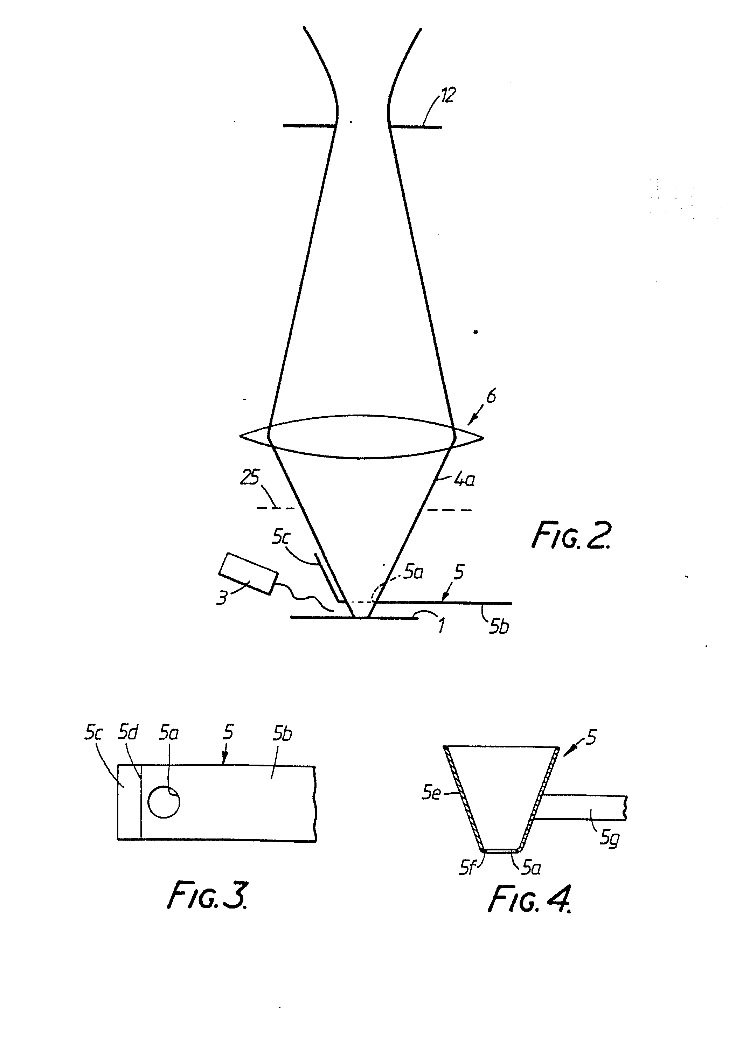

The present invention is illustrated diagrammatically in Figures 2 to 4, and Figure 2 shows the second apertured plate 5 located as close as practicable to the specimen surface, for example 0.5 to 1.00mm above the specimen surface. This mask-forming plate contains an aperture 5a, for example of 0.1mm diameter, and the plate is movable to locate this aperture immediately above the selected area of the specimen, so that charged particles passing through aperture 5a are received only from a circular area of the specimen whose diameter is not greater than twice the diameter of the aperture 5a.

The plate 5 of Figure 3 comprises a flat portion 5b containing aperture 5a and a second mask-forming portion 5c which is inclined to the first portion and forms an extension of the first portion from a position closely adjacent the aperture 5a.

In its simplest form the mask-forming apertured plate 5 is formed from a flat plate of stainless steel or other non-magnetic material, for example of 5mm width, of which an end portion 5c is bent out of the plane of the main portion 5b along a transverse line 5d, the aperture 5a being located on the main portion 5b as close as possible to this line.

The angle between the inclined end portion 5c and the main portion is such that the end portion is tangential or nearly tangential to the periphery of the cone 4a which defines the path of electrons from the aperture 5a to the lens 6. With this arrangement, the end portion 5c, which faces the source of radiation, will screen the downstream face of the mask from the radiation. However it will not interfere with the passage of radiation to the specimen provided that the mask is sufficiently spaced above the specimen and the aperture is sufficiently close to the end portion 5c.

This apertured mask-forming plate 5 enables extremely small areas, for example of 0.1mm diameter, to be selected and electrons to be collected with better signal-to-background ratios than are normal with present techniques. The selected area is more sharply defined than that obtained from an aberration limited lens by reason of the closeness of the plate 5 to the specimen.

Moreover, the selected area position is fixed by the apertured plate and this is not perturbed by stray magnetic field effects.

As an alternative to the embodiment of Figures 2 and 3, the plate 5 can take the form, shown in Figure 4, of a truncated conical shell 5e the small end 5f of which contains the aperture 5a. A support 5g is attached to the shell 5e for supporting and adjusting the position of the conical shell 5e.

The mask-forming plate 5 can be substituted for the normal collection angle aperture, although if desired a collection angle aperture can additionally be provided, in the normal position shown at 25 in Figure 2.

## CLAIMS

1.      A charged particle analyser having an axis
along which charged particles can pass, means for
mounting a specimen (1) in a specimen position on the
axis of the analyser, a radiation source (3) for
directing radiation at an acute angle to said axis on to
the surface of a specimen located in said specimen
position to cause charged particles to be emitted from
said specimen, analysing means (14) for analysing
charged particles received from said specimen, a lens
(6) on said axis between the specimen position and the
analysing means, a first plate (12) having an aperture
(12a), the aperture being located on said axis between
said lens and said analysing means, said lens and the
size and location of the first plate aperture broadly
defining a selected area of the specimen from which the
analysing means can receive charged particles, and a
second plate (5) containing an aperture (5a), the
aperture of the second plate being located on said axis
between the lens and the specimen position, said second
plate (5) having a masking portion (5c or 5e) which
masks the downstream facing side of the second plate
from the radiation characterised in that the second
apertured plate (5) is arranged so close to the specimen
position      as      to      limit      the      area      of      the specimen from which the lens can receive charged particles to a circle whose diameter is not greater than twice the diameter of the aperture (5a) of the second plate (5).

2.      A charged particle analyser according to claim 1 characterised in that the second apertured plate is in the form of a truncated conical shell (5e).

FIG. 1.

FIG. 2.

FIG. 3.

FIG. 4.